# EUROPEAN PATENT SPECIFICATION

(11) **EP 3 371 812 B1**
(45) Date of publication and mention of the grant of the patent: **19.05.2021**
(21) Application number: 16862683.6
(22) Date of filing: 14.10.2016
(51) Int. Cl.: H01L 21/336, H01L 21/8239, H01L 29/778, H01L 29/788, H01L 27/11524, H01L 21/28, H01L 29/423, H01L 29/51, H01L 29/66, H01L 29/49

(54) **INTEGRATION OF METAL FLOATING GATE IN NON-VOLATILE MEMORY**
INTEGRATION EINES SCHWEBENDEN METALLGATES IN EINEM NICHTFLÜCHTIGEN SPEICHER
INTÉGRATION DE GRILLE FLOTTANTE MÉTALLIQUE DANS UNE MÉMOIRE NON VOLATILE

(30) Priority: 03.11.2015 US 201562250002 P
(43) Date of publication of application: 12.09.2018
(73) Proprietor: Silicon Storage Technology, Inc., San Jose, CA 95134 (US)
(72) Inventor: ZHOU, Feng, Fremont, CA 94536 (US); LIU, Xian, Sunnyvale, CA 94087 (US); YANG, Jeng-Wei, Zhubei City Hsinchu County 302 (TW); DO, Nhan, Saratoga, CA 95070 (US)
(74) Representative: Betten & Resch
(86) International application number: PCT/US2016/057222
(87) International publication number: WO 2017/078918

(56) References cited:
- US-A1- 2006 172 490
- US-A1- 2008 217 675
- US-A1- 2009 321 810
- US-A1- 2010 054 043
- US-A1- 2013 285 133
- US-A1- 2015 036 437
- US-A1- 2015 137 207
- US-B1- 8 101 477
- CHEN GUOXING ET AL: "Metal Floating Gate Memory Device With SiO2/HfO2 Dual-Layer as Engineered Tunneling Barrier", IEEE ELECTRON DEVICE LETTERS, IEEE SERVICE CENTER, NEW YORK, NY, US, vol. 35, no. 7, 1 July 2014 (2014-07-01), pages 744-746, XP011552144, ISSN: 0741-3106, DOI: 10.1109/LED.2014.2320971 [retrieved on 2014-06-24]

## Description

### RELATED APPLICATIONS

### FIELD OF THE INVENTION

The present invention relates to non-volatile memory cells and their fabrication.

### BACKGROUND OF THE INVENTION

Non-volatile memory devices are well known in the art. For example, U.S. Patent 7,868,375 discloses a memory cell having a floating gate, a select gate, an erase gate and a control gate. These conductive gates are formed of polysilicon. When such memory cells are formed on the same wafer as logic devices, there is a need to reduce the overall height of the memory cells so that the memory cell height better matches the lower height of the logic devices (i.e., so the memory cells and their formation are more compatible with the logic devices and their formation). Therefore, there are constant efforts to scale down the height of the memory stacks (which includes both the floating gate and the control gate). However, scaling down the sizes of these polysilicon gates can be problematic. For example, scaling down the thickness of the polysilicon floating gate can result in ballistic transport of electrons through the floating gate and into the inter-poly dielectric during program and/or erase operations, thus causing reliability issues.

### BRIEF SUMMARY OF THE INVENTION

The aforementioned problems and needs are addressed by a non-volatile memory cell that includes a silicon substrate, source and drain regions formed in the silicon substrate, wherein a channel region of the substrate is defined between the source and drain regions, a metal floating gate disposed over and insulated from a first portion of the channel region, a metal control gate disposed over and insulated from the metal floating gate, a polysilicon erase gate disposed over and insulated from the source region, and a polysilicon word line gate disposed over and insulated from a second portion of the channel region.

A method of forming a non-volatile memory cell includes forming source and drain regions in a silicon substrate, wherein a channel region of the substrate is defined between the source and drain regions, forming a first insulation layer on the substrate, forming a metal floating gate on the first insulation layer and over a first portion of the channel region, forming a second insulation layer on the metal floating gate, forming a metal control gate on the second insulation layer and over the metal floating gate, forming a polysilicon erase gate over and insulated from the source region, and forming a polysilicon word line gate over and insulated from a second portion of the channel region.

Other objects and features of the present invention will become apparent by a review of the specification, claims and appended figures.

### BRIEF DESCRIPTION OF THE DRAWINGS

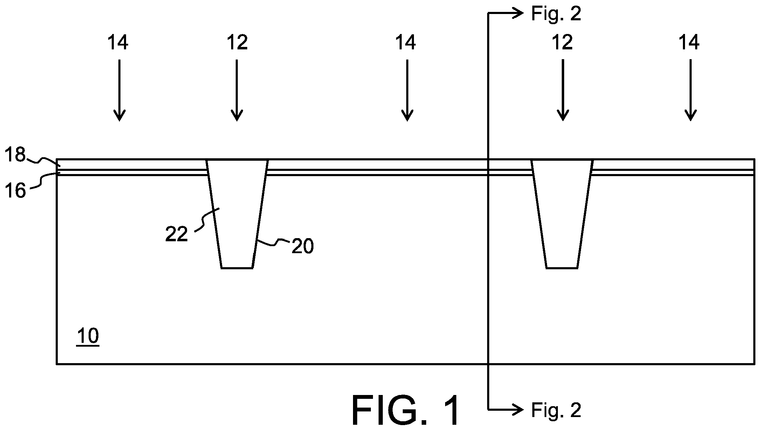

Figs. 1-11 are side cross sectional views illustrating the steps in forming the non-volatile memory cells of the present invention.

### DETAILED DESCRIPTION OF THE INVENTION

The present invention provides the ability to scale the memory cells down in height in a manner that reduces ballistic transport through the floating gate. Fig. 1 illustrates the beginning of the process in forming the memory cells. Starting with a silicon substrate 10, isolation regions 12 are formed in the substrate (defining active regions 14 there between) by forming an oxide layer 16 over the substrate 10, and a nitride layer 18 over the oxide layer 16. A photolithography masking step is used to cover the structure with photo resist except for the isolation regions 12 which are left exposed, whereby the oxide, nitride and substrate silicon are etched to form trenches 20 that extend down into the substrate 10. These trenches are then filled with oxide 22 by oxide deposition and oxide CMP (chemical mechanical polish), and oxide anneal, as shown in Fig. 1. This technique of forming isolation regions of STI (shallow trench isolation) oxide is well known in the art and not further discussed.

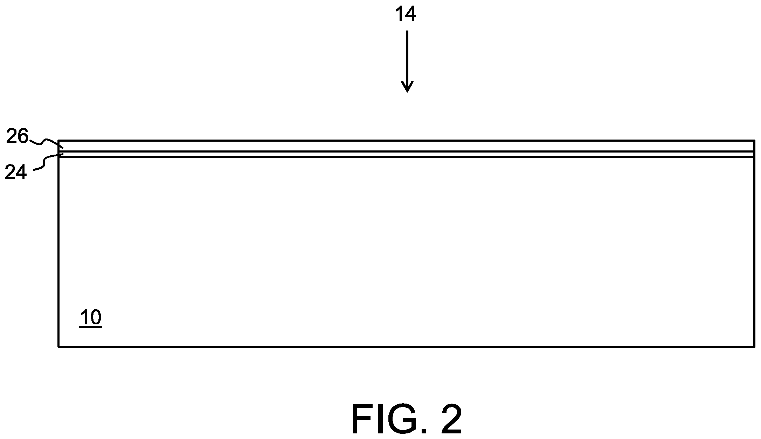

The memory cell formation discussed below is performed in the active regions 14 between adjacent STI isolation regions 12. After removal of nitride 18 and oxide 16, a floating gate (FG) insulation layer 24 is formed over the substrate 10. Insulation layer 24 can be SiO₂, SiON, a high K dielectric (i.e. an insulation material having a dielectric constant K greater than that of oxide, such as HfO₂, ZrO₂, TiO₂, Ta₂O₅, Al₂O₃, nitridation treated oxide or other adequate materials, etc.), or an IL/HK stack (where the interfacial layer (IL) is a thin silicon oxide layer disposed on the substrate, and the HK layer is disposed on the IL layer). Using an IL/HK stack will suppress tunneling leakage from the floating gate to the channel, and thus improve the data retention performance. A floating gate (FG) metal layer 26 is then deposited on insulation layer 24. The metal layer 26 can be any type of metal/alloy with a work function WF close to the silicon conduction band. Examples of preferred materials for the metal layer 26 include TaN, TaSiN, TiN/TiAl/TiN (i.e. sublayers of TiN, TiAl and TiN), TiN/AlN/TiN (i.e. sublayers of TiN, AlN and TiN), etc. When IL/HK is used for the insulation layer 24, TiN is preferred for the metal layer 26 due to process compatibility. The thickness of metal layer 26 can be around 100A to get better WF stability and process control. The metal layer 26 contains no polysilicon. The resulting structure (in the active regions 14) is shown in Fig. 2.

It should be noted that TiN has an effective WF (EWF) that is suitable for PMOS (4.4 eV). However, with aluminum (Al) incorporation into the TiN layer, the EWF can be reduced. Titanium aluminum (TiAl), Al and AlN layer(s) can be introduced to reduced EWF. For example, the EWF for TiN/TiAl/TiN can be reduced to about 1eV. AIN/TiN can also reduce the EWF to about 0.5 eV. TaN has an effective WF of about 3.75eV, which is more suitable for NMOS, and can be tuned by Al incorporation.

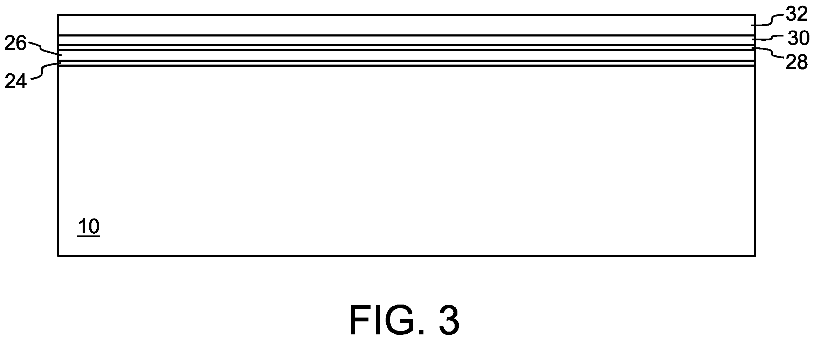

An inter-gate dielectric (IGD) layer 28 is then formed over the metal layer 26. The IGD layer 28 can use high K dielectric material(s), as this will effectively reduce the ballistic leakage current and related reliability issues. A high K IGD layer 28 will also increase the control gate (CG) to floating gate (FG) coupling ratio to improve the program performance. The thickness of the IGD layer 28 can be around 100-200A. A post deposition RTP anneal can be applied to densify the film to improve its quality and improve reliability. A tri-sublayer IGD layer 28 (i.e., HfO₂/Al₂O₃/HfO₂) is preferred because using only HfO₂ may have higher leakage current if the subsequent annealing temperature is higher than its crystallization temperature. A control gate (CG) metal layer 30 is then deposited over the IGD layer 28. The CG metal layer 30 can be any type of n-type metal(s) such as TaN, TaSiN, TiN/TiAl/TiN, TiN/AlN/TiN, W, etc. The thickness of the CG metal layer 30 can be around 200A. The CG metal layer 30 contains no polysilicon. A hard mask layer (HM) 32 is then formed on the CG metal layer 30. The HM layer 32 can be nitride, a Nitride/Oxide/Nitride tri-layer stack, or any other appropriate insulator. Layer 32 will protect against dry etch loss during the CG/IGD/FG stack etch. The resulting structure is shown in Fig. 3.

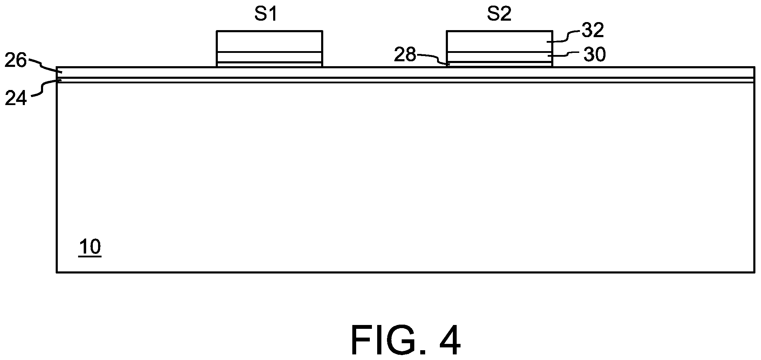

A photolithography masking step is performed to form photo resist over the structure, and to selectively remove the photo resist to leave portions of the underlying HM layer 32 exposed. An etch process is performed to remove the exposed portions of the HM layer 32 and CG metal layer 30. For a nitride HM layer 32, this etch can use a nitride and metallic TaN etch recipe, using the IGD layer 28 as an etch stop. The exposed portions of the IGD layer 28 (either HK or ONO) are then removed by a timed dry etch. The resulting structure is shown in Fig. 4 (after removal of the photoresist). This structure includes pairs of memory stack structures S1 and S2.

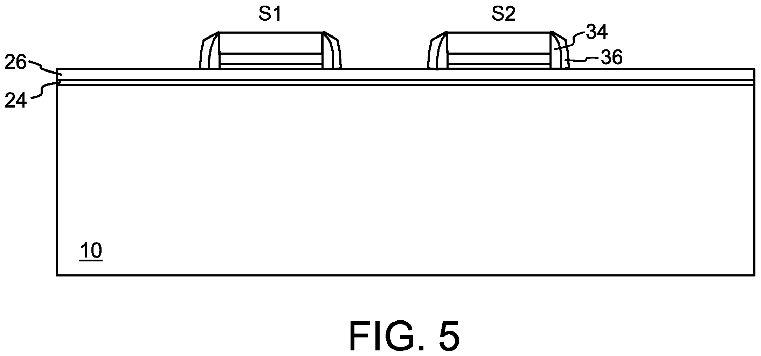

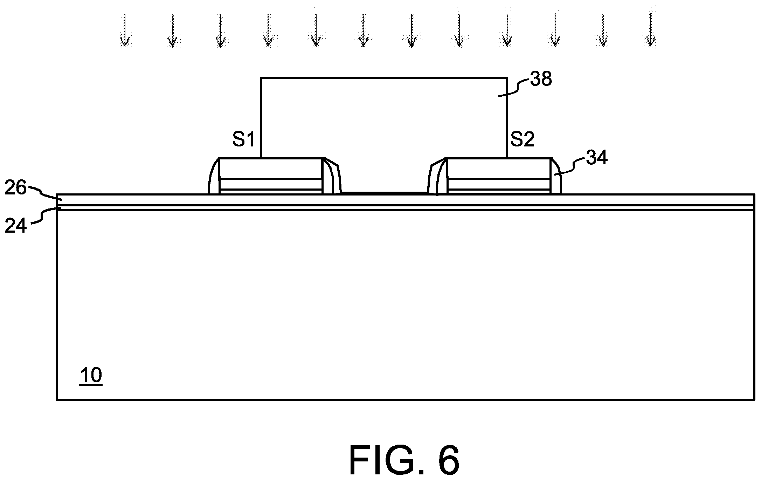

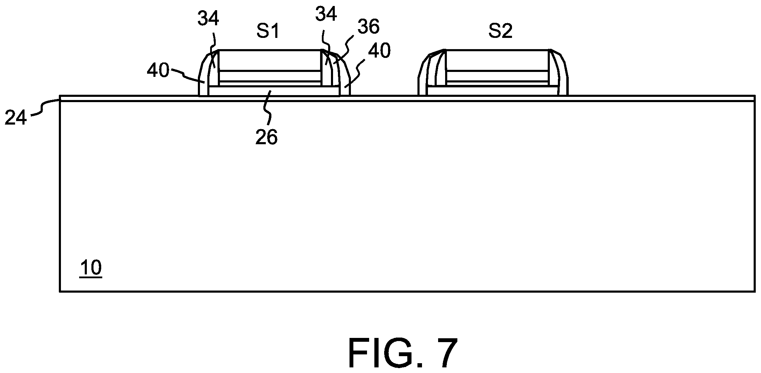

Oxide and nitride are deposited on the structure, followed by oxide and nitride etches that remove these materials except for spacers 34 thereof along the sides of the stacks S1 and S2. Sacrificial spacers 36 are formed along spacers 34 (e.g. by TEOS oxide deposition and anisotropic etch), as shown in Fig. 5. Photo resist 38 is then formed in the area between stacks S1 and S2 (herein referred to as the inner stack area), and extending partially over stacks S1 and S2 themselves. Those areas outside of stacks S1 and S2 (herein referred to as the outer stack areas) are left exposed by the photo resist 38. A WL Vt implantation is then performed, followed by an oxide etch that removes the sacrificial spacers 36 in outer stack areas, as shown in Fig. 6. After the photoresist 38 is removed, a metal etch is performed to remove those exposed portions of the FG metal layer 26 (i.e., those portions not protected by stacks S 1 and S2). Oxide spacers 40 are then formed on the sides of stacks S1 and S2, preferably by HTO deposition, anneal and etch, as shown in Fig. 7. Processing steps for forming low and high voltage (LV and HV) logic devices on the same wafer can be performed at this time. For example, a masking step can be used to cover the memory cell area and the LV logic device area with photoresist, while leaving open the HV logic device area. RTO oxide, HTO deposition, logic well implantation and LV well activation steps can then be performed.

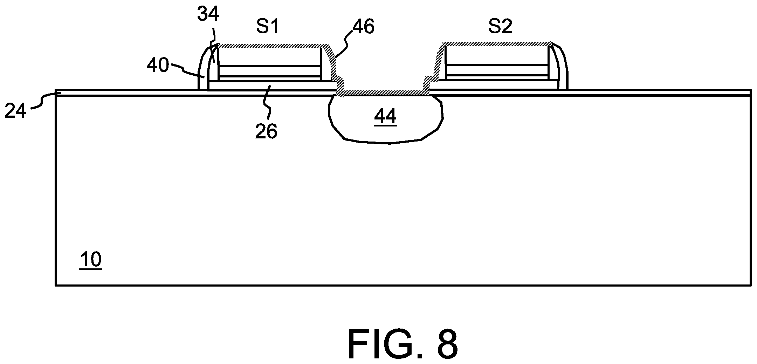

Photoresist is then formed over the outer stack areas and partially over stacks S 1 and S2, leaving the inner stack area exposed. A HVII implantation is then performed for the inner stack area for forming the source region 44 (source line SL). An oxide etch is then used to remove the oxide spacers 40 and 36 and oxide layer 24 from the inner stack area. After photoresist removal, a HVII implant anneal is then performed to complete the formation of the source region 44. A tunnel oxide layer 46 is then formed in the inner stack area and on the stacks S1 and S2 by depositing oxide over the entire structure, as shown in Fig. 8 (which increases the thickness of spacers 40 and oxide layer 24). Additional processing steps for forming the LV and HV logic devices can be performed at this time. For example, masking steps and gate oxide layer formation steps can be performed to form layers of oxide of different thicknesses in the LV and HV logic device areas in preparation for forming the logic gates.

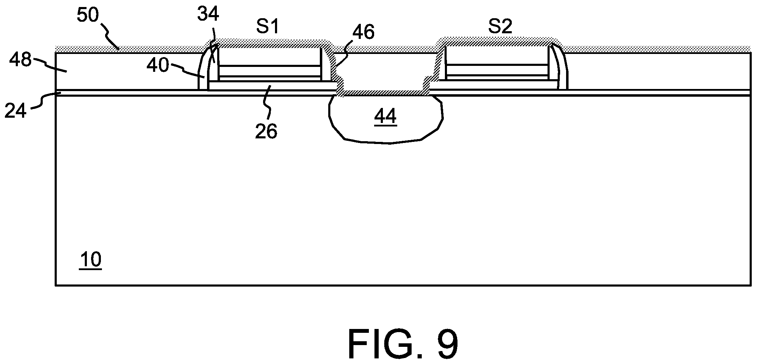

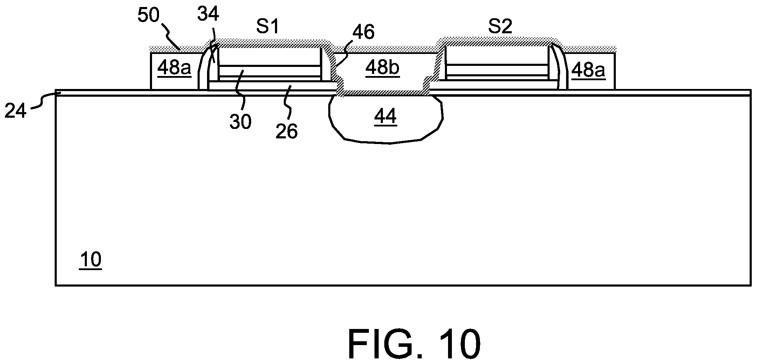

A thick layer of polysilicon (poly) 48 is deposited over the structure, followed by a chemical mechanical polish to reduce the height of the poly layer 48 to the tops of stacks S1 and S2. A further poly etch back is used to reduce the height of the poly layer 48 below the tops of stacks S1 and S2. A hard mask (e.g. nitride) layer 50 is then deposited on the structure, as shown in Fig. 9. A series of masking steps are performed to selectively expose the portions of the nitride and poly in the logic area, followed by nitride/poly etches to form the conductive poly logic gates, and to selectively expose portions of the outer stack areas, followed by nitride/poly etches to remove exposed portions of HM layer 50 and poly 48, which defines the outer edges of the remaining poly blocks 48a that will eventually become the word lines (WL), as shown in Fig. 10. After photoresist removal, a MCEL masking step is performed, followed by an implant step.

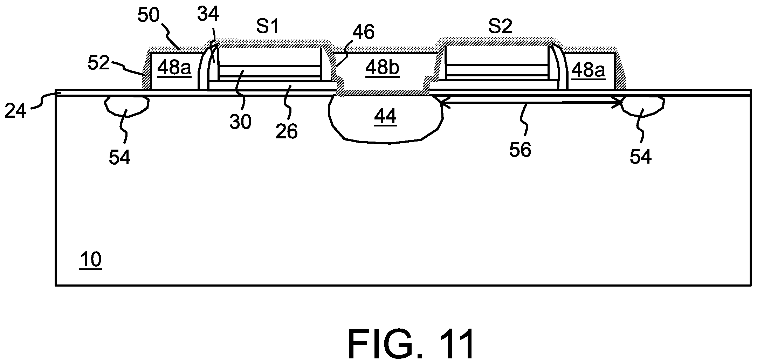

Spacers 52 are formed alongside the structure in the memory area by oxide and nitride depositions and etches. Masking and implant steps are performed to form drain regions (also referred to bit line contact regions) 54 on either side of the memory stacks S 1 and S2. The final structure is shown in Fig. 11. The memory cells are formed in pairs sharing a single source region 44. Each memory cell includes a source region 44 and drain region 54 in the substrate 10 (defining a channel region 56 there between), a metal floating gate 26 disposed over a first portion of the channel region, a polysilicon erase gate 48b disposed over and insulated from the source region 44, a metal control gate 30 disposed over and insulated from the floating gate 26, and a polysilicon word line gate 48a disposed over and insulated from a second portion of the channel region. By reducing the overall height of the stacks S1 and S2 by using metal floating and control gates 26/30, cell height can be reduced from about 120 nm to about 60 - 70 nm.

It is to be understood that the present invention, which is defined by the appended independent claims, is not limited to the embodiment(s) described above and illustrated herein. For example, references to the present invention herein are not intended to limit the scope of any claim or claim term, but instead merely make reference to one or more features that may be covered by one or more claim. Materials, processes and numerical examples described above are exemplary only, and should not be deemed to limit the claims. Further, not all method steps need be performed in the exact order illustrated, but rather in any order that allows the proper formation of the memory cell of the present invention. It is possible that some method step could be omitted. The control gate could instead be formed of polysilicon instead of a metal. Lastly, single layers of material could be formed as multiple layers of such or similar materials, and vice versa.

It should be noted that, as used herein, the terms "over" and "on" both inclusively include "directly on" (no intermediate materials, elements or space disposed therebetween) and "indirectly on" (intermediate materials, elements or space disposed therebetween). Likewise, the term "adjacent" includes "directly adjacent" (no intermediate materials, elements or space disposed therebetween) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements therebetween, as well as forming the element indirectly on the substrate with one or more intermediate materials/elements therebetween.

## Claims

1. A non-volatile memory cell, comprising:
a silicon substrate (10);
source (44) and drain (54) regions formed in the silicon substrate, wherein a channel region (56) of the substrate is defined between the source and drain regions;
a metal floating gate (26) disposed over and insulated from a first portion of the channel region;
a metal control gate (30) disposed over and insulated from the metal floating gate;
a polysilicon erase gate (48b); and
a polysilicon word line gate (48a) disposed over and insulated from a second portion of the channel region, **characterised in that** the polysilicon erase gate is disposed over and insulated from the source region.

2. The non-volatile memory cell of claim 1, wherein the metal floating gate is insulated from the substrate by a layer of high K dielectric material.

3. The non-volatile memory cell of claim 2, wherein the high K dielectric material is at least one of HfO₂, ZrO₂, TiO₂, Ta₂O₅, Al₂O₃, and nitridation treated oxide.

4. The non-volatile memory cell of claim 2, wherein the metal floating gate is further insulated from the substrate by a layer of oxide.

5. The non-volatile memory cell of claim 4, wherein the metal floating gate comprises TiN.

6. The non-volatile memory cell of claim 1, wherein the metal floating gate comprises at least one of TaN, TaSiN, TiN/TiAl/TiN, and TiN/AIN/TiN; or
wherein the metal floating gate comprises Al and at least one of TiN and TaN; or
wherein the metal floating gate comprises AIN and TiN.

7. The non-volatile memory cell of claim 1, wherein the metal control gate is insulated from the metal floating gate by one or more high K dielectric materials; or
wherein the metal control gate is insulated from the metal floating gate by a layer of Al₂O₃ disposed between layers of HfO₂; or
wherein the metal control gate comprises at least one of TaN, TaSiN, TiN/TiAl/TiN, TiN/AIN/TiN and W.

8. A method of forming a non-volatile memory cell, comprising:
forming source (44) and drain (54) regions in a silicon substrate (10), wherein a channel region of the substrate (56) is defined between the source and drain regions;
forming a first insulation layer (24) on the substrate;
forming a metal floating gate (26) on the first insulation layer and over a first portion of the channel region;
forming a second insulation layer (28) on the metal floating gate;
forming a metal control gate (30) on the second insulation layer and over the metal floating gate;
forming a polysilicon erase gate (48b); and
forming a polysilicon word line gate (48a) over and insulated from a second portion of the channel region, **characterised in that** the polysilicon erase gate is formed over and insulated from the source region.

9. The method of claim 8, wherein the first insulation layer comprises a high K dielectric material.

10. The method of claim 9, wherein the high K dielectric material is at least one of HfO₂, ZrO₂, TiO₂, Ta₂O₅, Al₂O₃, and nitridation treated oxide.

11. The method of claim 8, wherein the first insulation layer comprises an oxide layer and a layer of high K dielectric material.

12. The method of claim 11, wherein the metal floating gate comprises TiN.

13. The method of claim 8, wherein the metal floating gate comprises at least one of TaN, TaSiN, TiN/TiAl/TiN, and TiN/AIN/TiN; or
wherein the metal floating gate comprises Al and at least one of TiN and TaN; or
wherein the metal floating gate comprises AIN and TiN.

14. The method of claim 8, wherein the forming of the second insulation layer comprises:
depositing insulation material on the metal floating gate; and
annealing the deposited insulation material.

15. The method of claim 8, wherein the second insulation layer comprises one or more high K dielectric materials or
wherein the second insulation layer comprises a layer of Al₂O₃ disposed between layers of HfO₂; or
wherein the metal control gate comprises at least one of TaN, TaSiN, TiN/TiAl/TiN, TiN/AlN/TiN and W.

## Patentansprüche

1. Nichtflüchtige Speicherzelle, umfassend:
ein Siliziumsubstrat (10);
Source- (44) und Drainbereiche (54), die in dem Siliziumsubstrat ausgebildet sind, wobei ein Kanalbereich (56) des Substrats zwischen dem Source- und Drainbereich definiert ist;
ein schwebendes Metallgate (26), das über einem ersten Abschnitt der Kanalregion angeordnet und von diesem isoliert ist;
ein Metall-Steuer-Gate (30), das über dem ersten schwebenden Metallgate angeordnet und von diesem isoliert ist;
ein Polysiliziumlöschgate (48b); und
ein Polysiliziumwortleitungsgate (48a), das über einem zweiten Abschnitt des Kanalbereichs angeordnet und von diesem isoliert ist, **dadurch gekennzeichnet, dass** das Polysiliziumlöschgate über dem Sourcebereich angeordnet und von diesem isoliert ist.

2. Nichtflüchtige Speicherzelle nach Anspruch 1, wobei das schwebende Metallgate von dem Substrat durch eine Schicht aus high-K-dielektrischem Material isoliert ist.

3. Nichtflüchtige Speicherzelle nach Anspruch 2, wobei das high-K-dielektrische Material mindestens eines von HfO₂, ZrO₂, TiO₂ Ta₂O₅, Al₂O₃ und nitrierungsbehandeltes Oxid ist.

4. Nichtflüchtige Speicherzelle nach Anspruch 2, wobei das schwebende Metallgate ferner von dem Substrat durch eine Oxidschicht isoliert ist.

5. Nichtflüchtige Speicherzelle nach Anspruch 4, wobei das schwebende Metallgate TiN umfasst.

6. Nichtflüchtige Speicherzelle nach Anspruch 1, wobei das schwebende Metallgate mindestens eines von TaN, TaSiN, TiN/TiAl/TiN und TiN/AlN/TiN umfasst; oder
wobei das schwebende Metallgate Al und mindestens eines von TiN und TaN umfasst; oder
wobei das schwebende Metallgate AIN und TiN umfasst.

7. Nichtflüchtige Speicherzelle nach Anspruch 1, wobei das Metall-Steuer-Gate von dem schwebenden Metallgate durch ein oder mehrere high-K-dielektrische Materialien isoliert ist; oder
wobei das Metall-Steuer-Gate von dem schwebenden Metallgate durch eine Schicht aus Al₂O₃ isoliert ist, die zwischen Schichten aus HfO₂ angeordnet ist; oder
wobei das Metall-Steuer-Gate mindestens eines von TaN, TaSiN, TiN/TiAl/TiN, TiN/AlN/TiN und W umfasst.

8. Verfahren zum Ausbilden einer nichtflüchtigen Speicherzelle, umfassend:
Ausbilden von Source- (44) und Drainbereichen (54) in einem Siliziumsubstrat (10), wobei ein Kanalbereich des Substrats (56) zwischen den Source- und Drainbereichen definiert ist;
Ausbilden einer ersten Isolierschicht (24) auf dem Substrat;
Ausbilden eines schwebenden Metallgates (26) auf der ersten Isolierschicht und über einem ersten Abschnitt des Kanalbereichs;
Ausbilden einer zweiten Isolierschicht (28) auf dem schwebenden Metallgate;
Ausbilden eines Metall-Steuer-Gates (30) auf der zweiten Isolierschicht und über dem schwebenden Metallgate;
Ausbilden eines Polysiliziumlöschgates (48b); und
Ausbilden eines Polysiliziumwortleitungsgates (48a) über einem zweiten Abschnitt des Kanalbereichs und von diesem isoliert, **dadurch gekennzeichnet, dass** das Polysiliziumlöschgate über dem Sourcebereich ausgebildet und von diesem isoliert ist.

9. Verfahren nach Anspruch 8, wobei die erste Isolierschicht ein high-K-dielektrisches Material umfasst.

10. Verfahren nach Anspruch 9, wobei das high-K-dielektrische Material mindestens eines von HfO₂, ZrO₂, TiO₂, Ta₂O₅, Al₂O₃, und nitrierungsbehandeltes Oxid ist.

11. Verfahren nach Anspruch 8, wobei die erste Isolierschicht eine Oxidschicht und eine Schicht aus high-K-dielektrischem Material K umfasst.

12. Verfahren nach Anspruch 11, wobei das schwebende Metallgate TiN umfasst.

13. Verfahren nach Anspruch 8, wobei das schwebende Metallgate mindestens eines von TaN, TaSiN, TiN/TiAl/TiN und TiN/AlN/TiN umfasst; oder
wobei das schwebende Metallgate Al und mindestens eines von TiN und TaN umfasst; oder
wobei das schwebende Metallgate AIN und TiN umfasst.

14. Verfahren nach Anspruch 8, wobei das Ausbilden der zweiten Isolierschicht Folgendes umfasst:
Abscheiden von Isoliermaterial auf dem schwebenden Metallgate; und
Tempern des abgeschiedenen Isoliermaterials.

15. Verfahren nach Anspruch 8, wobei die zweite Isolierschicht ein oder mehrere high-K-dielektrische Materialien umfasst oder
wobei die zweite Isolierschicht eine Schicht aus Al₂O₃ umfasst, die zwischen Schichten aus HfO₂ angeordnet ist; oder
wobei das Metall-Steuer-Gate mindestens eines von TaN, TaSiN, TiN/TiAl/TiN, TiN/AlN/TiN und W umfasst.

## Revendications

1. Cellule de mémoire non volatile, comprenant :
un substrat de silicium (10) ;
des régions de source (44) et de drain (54) formées dans le substrat de silicium, dans laquelle une région de canal (56) du substrat est définie entre les régions de source et de drain ;
une grille flottante en métal (26) disposée par-dessus et isolée d'une première partie de la région de canal ;
une grille de commande en métal (30) disposée par-dessus et isolée de la grille flottante en métal ;
une grille d'effacement en silicium polycristallin (48b) ; et
une grille de ligne de mot en silicium polycristallin (48a) disposée par-dessus et isolée d'une deuxième partie de la région de canal, **caractérisée en ce que** la grille d'effacement en silicium polycristallin est disposée par-dessus et isolée de la région de source.

2. Cellule de mémoire non volatile selon la revendication 1, dans laquelle la grille flottante en métal est isolée du substrat par une couche de matériau diélectrique à coefficient K élevé.

3. Cellule de mémoire non volatile selon la revendication 2, dans laquelle le matériau diélectrique à coefficient K élevé est au moins l'un parmi HfO₂, ZrO₂, TiO₂, Ta₂O₅, Al₂O₃, et un oxyde traité par nitruration.

4. Cellule de mémoire non volatile selon la revendication 2, dans laquelle la grille flottante en métal est en outre isolée du substrat par une couche d'oxyde.

5. Cellule de mémoire non volatile selon la revendication 4, dans laquelle la grille flottante en métal comprend TiN.

6. Cellule de mémoire non volatile selon la revendication 1, dans laquelle la grille flottante en métal comprend au moins l'un parmi TaN, TaSiN, TiN/TiAl/TiN, et TiN/AlN/TiN ; ou
dans laquelle la grille flottante en métal comprend Al et au moins l'un parmi TiN et TaN ; ou
dans laquelle la grille flottante en métal comprend AIN et TiN.

7. Cellule de mémoire non volatile selon la revendication 1, dans laquelle la grille de commande en métal est isolée de la grille flottante en métal par un ou plusieurs matériaux diélectriques à coefficient K élevé ; ou
dans laquelle la grille de commande en métal est isolée de la grille flottante en métal par une couche d'Al₂O₃ disposée entre des couches de HfO₂ ; ou
dans laquelle la grille de commande en métal comprend au moins l'un parmi TaN, TaSiN, TiN/TiAl/TiN, TiN/AlN/TiN et W.

8. Procédé de formation d'une cellule de mémoire non volatile, comprenant :
la formation de régions de source (44) et de drain (54) formées dans le substrat de silicium (10), dans lequel une région de canal du substrat (56) est définie entre les régions de source et de drain ;
la formation d'une première couche d'isolation (24) sur le substrat ;
la formation d'une grille flottante en métal (26) sur la première couche d'isolation et par-dessus une première partie de la région de canal ;
la formation d'une deuxième couche d'isolation (28) sur la grille flottante en métal ;
la formation d'une grille de commande en métal (30) sur la deuxième couche d'isolation et par-dessus la grille flottante en métal ;
la formation d'une grille d'effacement en silicium polycristallin (48b) ; et
la formation d'une grille de ligne de mot en silicium polycristallin (48a) par-dessus et isolée d'une deuxième partie de la région de canal, **caractérisé en ce que** la grille d'effacement en silicium polycristallin est formée par-dessus et isolée de la région de source.

9. Procédé selon la revendication 8, dans lequel la première couche d'isolation comprend un matériau diélectrique à coefficient K élevé.

10. Procédé selon la revendication 9, dans lequel le matériau diélectrique à coefficient K élevé est au moins l'un parmi HfO₂, ZrO₂, TiO₂, Ta₂O₅, Al₂O₃, et un oxyde traité par nitruration.

11. Procédé selon la revendication 8, dans lequel la première couche d'isolation comprend une couche d'oxyde et une couche de matériau diélectrique à coefficient K élevé.

12. Procédé selon la revendication 11, dans lequel la grille flottante en métal comprend TiN.

13. Procédé selon la revendication 8, dans lequel la grille flottante en métal comprend au moins l'un parmi TaN, TaSiN, TiN/TiAl/TiN, et TiN/AlN/TiN ; ou
dans lequel la grille flottante en métal comprend Al et au moins l'un parmi TiN et TaN ; ou
dans lequel la grille flottante en métal comprend AIN et TiN.

14. Procédé selon la revendication 8, dans lequel la formation de la deuxième couche d'isolation comprend :
le dépôt d'un matériau d'isolation sur la grille flottante en métal ; et
le recuit du matériau d'isolation déposé.

15. Procédé selon la revendication 8, dans lequel la deuxième couche d'isolation comprend un ou plusieurs matériaux diélectriques à coefficient K élevé ou
dans lequel la deuxième couche d'isolation comprend une couche d'Al₂O₃ disposée entre des couches de HfO₂ ; ou
dans lequel la grille de commande en métal comprend au moins l'un parmi TaN, TaSiN, TiN/TiAl/TiN, TiN/AlN/TiN et W.
